# FASCICULE DE BREVET EUROPEEN

(11) **EP 3 473 607 B1**
(45) Date de publication et mention de la délivrance du brevet: **08.01.2020**
(21) Numéro de dépôt: 18198904.7
(22) Date de dépôt: 05.10.2018
(51) Int. Cl.: C04B 35/52, C04B 35/80, C04B 35/83, F16D 69/02

(54) **PROCEDE DE FABRICATION D'UNE PIECE DE FRICTION EN MATERIAU COMPOSITE**
HERSTELLUNGSVERFAHREN EINES ABRIEBTEILS AUS VERBUNDMATERIAL
METHOD FOR PRODUCING A FRICTION PART MADE OF COMPOSITE MATERIAL

(30) Priorité: 19.10.2017 FR 1759867
(43) Date de publication de la demande: 24.04.2019
(73) Titulaire: Safran Landing Systems, 78140 Vélizy-Villacoublay (FR)
(72) Inventeur: BRENDER, Patrice, 38230 Charvieu-Chavagneux (FR); DEMEYER, Floriane, 33800 Bordeaux (FR); JACQUES, Sylvain, 33400 Talence (FR)
(74) Mandataire: Cabinet Beau de Loménie

(56) Documents cités:
- EP-A1- 2 253 604
- EP-A1- 3 181 720
- FR-A1- 2 880 016

## Description

La présente invention concerne un procédé de fabrication de pièces de friction à base de matériau composite carbone/carbone (C/C), telles que des disques de freins d'avions.

### Arrière-plan de l'invention

La demande EP 2 253 604 propose un procédé pour obtenir une pièce de friction en matériau composite carbone/carbone (C/C) incorporant une phase céramique. Cette pièce de friction présente une faible usure et un coefficient de friction adapté à l'application au freinage et stable, notamment lors de freinage à haute énergie.

Le procédé divulgué dans cette demande comprend la réalisation d'une préforme en fils de carbone, la densification de la préforme par une matrice de carbone et, au cours du processus de fabrication, l'introduction de grains ou particules en céramique dispersés au sein de la pièce. Plus précisément, la demande EP 2 253 604 divulgue de réaliser, préalablement à l'achèvement de la densification, une imprégnation par un liquide formé par une solution de type sol-gel et/ou une suspension colloïdale permettant la dispersion d'un ou plusieurs composé(s) du zirconium. Il est alors obtenu, dans la pièce finale, des grains ou cristallites dont la composition est au moins majoritairement de type ZrOₓC_{y} avec 1 ≤ x ≤ 2 et 0 ≤ y ≤ 1.

La pièce de friction obtenue par le procédé décrit dans la demande EP 2 253 604 présente de bonnes performances. En revanche, ce procédé est plus complexe que le procédé standard de réalisation d'un disque entièrement C/C. En effet dans cette demande, l'insertion du ou des composés à base de zirconium, est réalisée lors d'une étape par voie liquide, totalement dissociée de celle consistant à élaborer le pyrocarbone par densification par voie gazeuse (CVI).

En particulier, il est divulgué dans la demande EP 2 253 604 de réaliser l'insertion du zirconium, après un premier stade de densification par du pyrocarbone par CVI. La pièce est alors déchargée du four CVI puis immergée dans un sol précurseur de zircone, séchée et traitée thermiquement. La pièce est alors à nouveau introduite dans le four CVI, pour terminer la densification de la matrice pyrocarbone. Cette insertion du zirconium, totalement dissociée du procédé d'infiltration chimique en phase vapeur, occasionne une complexification et un rallongement de la fabrication.

Il serait souhaitable de simplifier le procédé de fabrication de pièces de friction en matériau composite C/C incorporant une phase céramique à base de zirconium.

### Objet et résumé de l'invention

L'invention vise, selon un premier aspect, un procédé de fabrication d'une pièce de friction en matériau composite, comprenant au moins l'étape suivante :
- densification d'une préforme fibreuse en fils de carbone par une matrice comprenant au moins du pyrocarbone et une phase ZrOₓC_{y}, où 1 ≤ x ≤ 2 et 0 ≤ y ≤ 1, la matrice étant formée par caléfaction ou par infiltration chimique en phase vapeur à partir d'un premier précurseur du pyrocarbone et d'un deuxième précurseur comprenant du zirconium, le deuxième précurseur étant un complexe du zirconium comprenant un ligand alcoxy ou carboxylate lié au zirconium.

Le deuxième précurseur décrit plus haut permet d'obtenir la phase ZrOₓC_{y} par caléfaction ou infiltration chimique en phase vapeur. Dans l'invention, le pyrocarbone et la phase ZrOₓC_{y} sont formés par le même procédé, soit par caléfaction, soit par infiltration chimique en phase vapeur, ce qui contribue à significativement simplifier l'obtention de la pièce par rapport aux techniques de l'art antérieur. L'utilisation conjointe des premier et deuxième précurseurs permet de former la matrice uniquement par caléfaction ou uniquement par CVI en s'affranchissant notamment des étapes supplémentaires d'imprégnation par le sol et de traitement thermique associé, ainsi que des étapes de déchargement du four et de rechargement dans le four effectuées dans l'état de la technique.

L'invention permet d'obtenir une pièce de friction ayant les performances souhaitées en termes tribologiques et de résistance à l'usure, de manière plus simple que dans l'art antérieur.

Dans un exemple de réalisation, la matrice est formée par caléfaction à partir d'un bain de caléfaction comprenant le premier et le deuxième précurseurs et la teneur massique en deuxième précurseur dans le bain de caléfaction est comprise entre 3% et 30%, par exemple entre 3% et 15%.

Dans un exemple de réalisation, la matrice est formée par infiltration chimique en phase vapeur et la densification comprend au moins :
- un premier cycle de densification dans lequel une première phase de matrice de pyrocarbone est formée à partir du premier précurseur à l'état gazeux,
- un deuxième cycle de densification, réalisé après le premier cycle, dans lequel une deuxième phase de matrice comprenant la phase ZrOₓC_{y} est formée au moins à partir du deuxième précurseur à l'état gazeux, et
- un troisième cycle de densification, réalisé après le deuxième cycle, dans lequel une troisième phase de matrice de pyrocarbone est formée à partir d'un troisième précurseur de pyrocarbone à l'état gazeux, identique ou différent du premier précurseur.

Dans un exemple de réalisation, la matrice est formée par infiltration chimique en phase vapeur et la densification comprend au moins la formation d'un co-dépôt du pyrocarbone et de la phase ZrOₓC_{y} à partir d'un mélange d'un précurseur gazeux de pyrocarbone et du deuxième précurseur à l'état gazeux.

Dans un exemple de réalisation, le ligand alcoxy ou carboxylate est en C₂ à C₁₀, par exemple en C₃ à C₈.

Dans un exemple de réalisation, le ligand alcoxy ou carboxylate est choisi parmi : le ligand propoxy, le ligand butoxy ou le ligand 2-éthylhexanoate.

Dans un exemple de réalisation, le deuxième précurseur est choisi parmi : le propoxyde de zirconium (Zr(OCH₂CH₂CH₃)₄), le butoxyde de zirconium (Zr(OC₄H₉)₄), l'éthyl-2-hexanoate de zirconium (Zr(OOCCH(C₂H₅)(CH₂)₃CH₃)₄), et leurs mélanges.

Dans un exemple de réalisation, le procédé comprend, en outre, un traitement thermique de désoxygénation de la phase ZrOₓC_{y} formée.

Dans un exemple de réalisation, la phase ZrOₓC_{y}, éventuellement désoxygénée, est présente, dans la pièce finale, en une teneur massique comprise entre 0,5% et 25%, par exemple comprise entre 2% et 10%.

Dans un exemple de réalisation, la pièce de friction est un disque de frein.

### Brève description des dessins

D'autres caractéristiques et avantages de l'invention ressortiront de la description suivante, donnée à titre non limitatif, en référence aux dessins annexés, sur lesquels :
- la figure 1 est un ordinogramme montrant différentes étapes d'un premier exemple de procédé selon l'invention,
- la figure 2 est un ordinogramme montrant différentes étapes d'un deuxième exemple de procédé selon l'invention,
- la figure 3 est un ordinogramme montrant différentes étapes d'un troisième exemple de procédé selon l'invention, et
- la figure 4 est une photographie d'une matrice formée dans le cadre d'un procédé selon l'invention.

### Description détaillée de modes de réalisation

Dans la description qui suit, il est plus particulièrement envisagé la réalisation de disques à base de matériau composite C/C pour des freins d'avion. Toutefois, l'invention est applicable à la réalisation d'autres pièces de friction à base de matériau composite C/C, telles que des disques de frein pour des véhicules terrestres, notamment des automobiles, et des pièces de friction autres que des disques, notamment des patins.

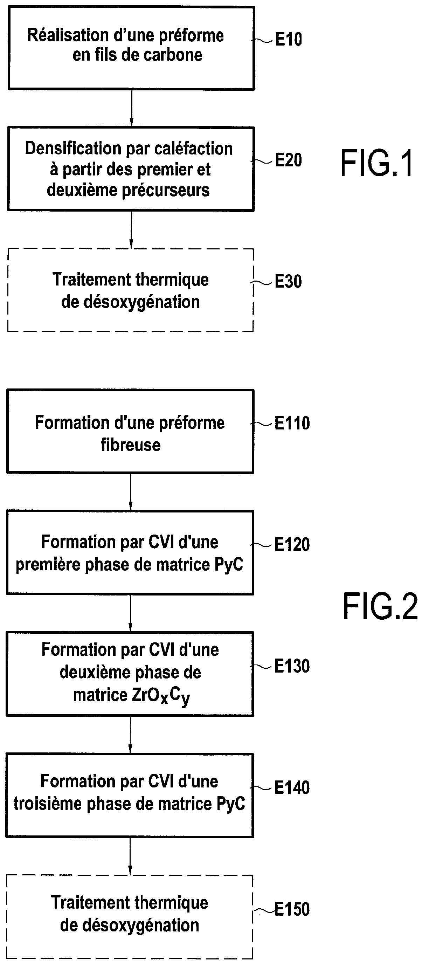

Un premier exemple de mise en œuvre d'un procédé selon l'invention est illustré par la figure 1 dans lequel la matrice est formée par caléfaction à partir du premier et du deuxième précurseurs.

Une première étape consiste à réaliser une préforme en fils de carbone pour disque de frein (étape E10).

Une telle préforme est par exemple réalisée par superposition de strates découpées dans une texture fibreuse en fils de précurseur de carbone, liaison des strates entre elles par aiguilletage et transformation du précurseur en carbone par traitement thermique.

En variante, on peut aussi réaliser une préforme annulaire par enroulement en spires superposées d'un tissu hélicoïdal en fils de précurseur de carbone, liaison des spires entre elles par aiguilletage et transformation du précurseur par traitement thermique. On pourra par exemple se référer aux documents US 5 792 715, US 6 009 605 et US 6 363 593.

On peut aussi réaliser la préforme directement à partir de strates de texture fibreuse en fils de carbone qui sont superposées et liées entre elles par exemple par aiguilletage.

Une fois la préforme formée, on réalise ensuite, dans l'exemple de la figure 1, une densification par caléfaction afin de densifier la préforme par la matrice (étape E20).

La préforme fibreuse à densifier est ici immergée dans un bain de caléfaction liquide comprenant un mélange du premier précurseur et du deuxième précurseur.

Un chauffage de la préforme est ensuite réalisé, par exemple par induction. La préforme est chauffée à une température supérieure à la température de décomposition des précurseurs. Au contact de la préforme chauffée, les premier et deuxième précurseurs sont vaporisés et génèrent par décomposition une matrice comprenant un mélange de pyrocarbone et de la phase ZrOₓC_{y}. Au cours du cycle de caléfaction, les premier et deuxième précurseurs vont être craqués. Les fils peuvent être revêtus par une matrice de pyrocarbone comprenant des inclusions de ZrOₓC_{y} encapsulées dans le pyrocarbone. La densité des inclusions de la phase ZrOₓC_{y} dans la matrice formée peut être constante. En particulier, la matrice formée peut avoir une composition uniforme. La préforme peut être maintenue dans le bain de caléfaction pendant la totalité de la formation de la matrice.

La matrice formée peut occuper au moins 50%, voire au moins 75%, de la porosité initiale de la préforme fibreuse. La porosité initiale de la préforme correspond à la porosité présentée par la préforme avant la réalisation d'une quelconque étape de densification.

Selon cet exemple, le premier précurseur constitue un précurseur de PyC classiquement utilisé en caléfaction, comme le cyclohexane, le toluène ou le chlorobenzène. Divers détails relatifs au deuxième précurseur seront fournis plus bas.

Le bain de caléfaction peut comporter :
- le premier précurseur en une teneur massique comprise entre 70% et 97%, par exemple entre 85% et 97%, et
- le deuxième précurseur en une teneur massique comprise entre 3% et 30%, par exemple entre 3% et 15%.

Sauf mention contraire, les teneurs massiques des précurseurs dans le bain de caléfaction sont prises avant le début de la densification.

Selon un exemple, le bain de caléfaction comprend uniquement le premier et le deuxième précurseurs.

La teneur en deuxième précurseur dans le bain de caléfaction détermine la teneur en phase ZrOₓC_{y} dans la matrice formée. Il va des connaissances générales de l'homme du métier de déterminer la teneur massique en deuxième précurseur à utiliser dans le bain de caléfaction afin d'obtenir la teneur souhaitée en phase ZrOₓC_{y} dans la matrice.

La température imposée pour former la matrice par caléfaction peut être comprise entre 800°C et 1600°C, par exemple entre 900°C et 1300°C.

Différents détails relatifs au deuxième précurseur vont à présent être décrits.

Le ligand alcoxy ou carboxylate peut être en C₂ à C₁₀, c'est-à-dire comprendre une chaîne carbonée ayant entre 2 et 10 atomes de carbone. Le ligand alcoxy ou carboxylate peut être en C₂ à C₈, voire en C₃ à C₈ ou en C₃ à C₁₀.

A titre d'exemple de ligand alcoxy ou carboxylate utilisable, on peut citer : un ligand propoxy (CH₃CH₂CH₂O-), un ligand butoxy (CH₃CH₂CH₂CH₂O-) ou un ligand 2-éthylhexanoate (CH₃(CH₂)₃CH(C₂H₅)COO-). Ces ligands ne sont fournis qu'à titre d'exemples, les complexes métalliques incorporant ces ligands correspondant simplement aux complexes les plus disponibles commercialement.

D'une manière générale, le deuxième précurseur présente la formule chimique suivante : Zr(L1)₄₋ₐ(L2)ₐ, où a est compris entre 0 et 3, L1 est le ligand alcoxy ou carboxylate évoqué plus haut et L2 est un ligand additionnel, différent de L1, éventuellement présent (présent si a est non nul).

A titre d'exemple, le ligand L2 peut être un ligand acétylacétonate (CH₃CO⁻CHCOCH₃), un ligand acétate (CH₃COO⁻) ou un ligand acide éthylène-diamine-tétra-acétique (EDTA) ou un ligand formé par une de ses bases conjuguées. La présence du ligand L2 est optionnelle et permet, si cela est souhaité, de moduler la réactivité du complexe métallique.

Selon une variante, le complexe du zirconium comprend uniquement le zirconium et le ligand alcoxy ou carboxylate (pas de ligand additionnel L2). Ainsi, le deuxième précurseur est par exemple choisi parmi : le propoxyde de zirconium (Zr(OCH₂CH₂CH₃)₄), le butoxyde de zirconium (Zr(OC₄H₉)₄), l'éthyl-2-hexanoate de zirconium (Zr(OOCCH(C₂H₅)(CH₂)₃CH₃)₄), et leurs mélanges.

Si cela est souhaité, un traitement thermique (étape E30 optionnelle) de désoxygénation peut être réalisé afin d'éliminer une partie au moins des liaisons existantes entre le zirconium et l'oxygène dans la phase ZrOₓC_{y} obtenue. Ce traitement permet de moduler la stoechiométrie de cette phase. On peut en particulier, après désoxygénation, transformer la phase ZrOₓC_{y} en phase de ZrC. Le traitement thermique de désoxygénation peut être réalisé, comme illustré à la figure 1, sur la pièce finale obtenue.

Le traitement thermique de désoxygénation constitue un traitement connu en soi. Il va des connaissances générales de l'homme du métier de déterminer la durée et la température à mettre en œuvre durant ce traitement de désoxygénation, en fonction du matériau souhaité à obtenir.

On vient de décrire un exemple dans lequel la matrice est formée par caléfaction à partir d'un bain comprenant à la fois le premier précurseur de PyC et le deuxième précurseur comprenant du zirconium. On forme ainsi, par caléfaction, un co-dépôt du pyrocarbone et de la phase ZrOₓC_{y}.

On ne sort toutefois pas du cadre de l'invention lorsque l'on forme séquentiellement par caléfaction une première phase de matrice PyC, puis une deuxième phase de matrice comprenant la phase ZrOₓC_{y}, puis une troisième phase de matrice PyC. On obtient ainsi une matrice séquencée comprenant au moins une première et troisième couches de PyC et une deuxième couche comprenant la phase ZrOₓC_{y} intercalée entre les première et troisième couches.

Cette matrice séquencée peut être réalisée en formant la première phase de matrice PyC à partir d'un premier bain de caléfaction comprenant un précurseur de PyC, la deuxième phase de matrice ZrOₓC_{y} à partir d'un deuxième bain de caléfaction comprenant le deuxième précurseur, et la troisième phase de matrice PyC à partir d'un troisième bain de caléfaction comprenant un précurseur de PyC. Le précurseur de PyC mis en œuvre pour former la troisième phase de matrice PyC peut être identique ou différent du précurseur de PyC mis en œuvre pour former la première phase de matrice PyC. Ce dépôt séquencé peut être réalisé dans un même réacteur dans lequel on réalise, entre la formation de deux phases de matrice successives, la vidange du bain de caléfaction et l'introduction d'un nouveau bain de caléfaction.

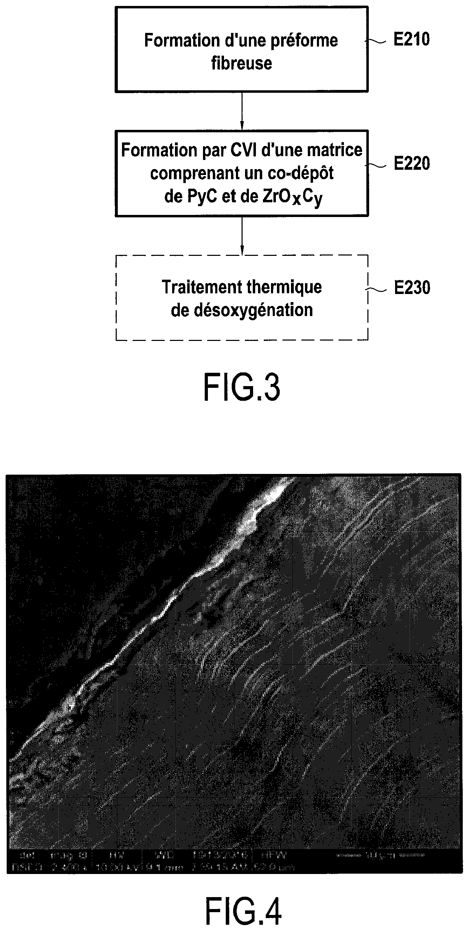

Il a été décrit le cas où la matrice est formée par caléfaction à partir des premier et deuxième précurseurs. Il va maintenant être décrit, en lien avec les figures 2 et 3, deux exemples de procédés selon l'invention dans lesquels la matrice est formée par infiltration chimique en phase vapeur à partir du premier et du deuxième précurseurs.

Comme dans l'exemple de la figure 1, la préforme fibreuse est, tout d'abord, fabriquée (étape E110).

La préforme est ensuite densifiée par la matrice en mettant en œuvre un procédé CVI.

Pour cela, la préforme fibreuse à densifier est placée dans une enceinte réactionnelle de CVI. On peut mettre en œuvre une enceinte réactionnelle adaptée à la formation de PyC, connue en soi.

Dans l'exemple associé à l'ordinogramme de la figure 2, la densification comprend un premier cycle de densification dans lequel une première phase de matrice PyC est formée par infiltration chimique en phase vapeur à partir du premier précurseur (étape E120). La première phase PyC peut être formée directement sur les fils formant la préforme.

On obtient, après le premier cycle de densification et avant le début du deuxième cycle de densification, une préforme partiellement densifiée par la première phase de matrice PyC. La première phase de matrice PyC peut occuper entre 5% et 40%, par exemple entre 15% et 25%, de la porosité initiale de la préforme fibreuse.

On réalise ensuite un deuxième cycle de densification durant lequel une deuxième phase de matrice comprenant la phase ZrOₓC_{y} est formée par infiltration chimique en phase vapeur au moins à partir du deuxième précurseur (étape E130). La deuxième phase de matrice peut être formée directement sur la première phase de matrice PyC. Selon cet exemple, l'introduction du deuxième précurseur gazeux dans l'enceinte réactionnelle est initiée lors du passage du premier au deuxième cycle de densification.

Selon un exemple, le deuxième précurseur peut constituer l'unique gaz réactif introduit dans l'enceinte réactionnelle durant le deuxième cycle de densification (pas de précurseur de PyC introduit dans ce cas). Auquel cas, on forme uniquement durant ce deuxième cycle la phase ZrOₓC_{y}.

En variante, on peut introduire, dans l'enceinte réactionnelle, un mélange gazeux d'un précurseur de PyC et du deuxième précurseur durant le deuxième cycle de densification. Auquel cas, on obtient un co-dépôt de la phase ZrOₓC_{y} et de PyC formé par infiltration chimique en phase vapeur. Dans ce dernier cas, le précurseur de PyC peut être le premier ou le troisième précurseur ou un précurseur de PyC différent du premier et du troisième précurseur.

La deuxième phase de matrice peut occuper entre 1% et 10%, par exemple entre 2% et 7%, de la porosité initiale de la préforme.

On réalise ensuite un troisième cycle de densification durant lequel une troisième phase de matrice PyC est formée par infiltration chimique en phase vapeur à partir d'un troisième précurseur gazeux de PyC, identique ou différent du premier précurseur (étape E140). La troisième phase de matrice peut être formée directement sur la deuxième phase de matrice. Selon cet exemple, l'introduction du deuxième précurseur dans l'enceinte réactionnelle est stoppée à la fin du deuxième cycle de densification et n'est pas reprise durant le troisième cycle de densification. La préforme peut être maintenue dans l'enceinte réactionnelle pendant la totalité de la formation de la matrice.

Le premier et le troisième précurseurs constituent des précurseurs de PyC classiquement utilisés en CVI et sont donc bien connus en soi. Le premier et le troisième précurseurs peuvent, indépendamment l'un de l'autre, être choisis parmi : le gaz naturel, le méthane, l'éthane, le propane, le benzène ou un mélange de ces composés.

Le deuxième précurseur utilisé dans la densification CVI peut être tel que décrit plus haut dans le cadre de la densification par caléfaction.

On peut réaliser, si cela est souhaité, un traitement thermique de désoxygénation de la même manière que décrite plus haut (étape E150).

La matrice formée par CVI à partir des premier et deuxième précurseurs peut occuper au moins 50%, voire au moins 75%, de la porosité initiale de la préforme fibreuse. Le troisième cycle de densification peut, en particulier, permettre de terminer la densification de la préforme.

La formation de la matrice par CVI dans le cadre de l'invention peut être mise en œuvre dans une installation de CVI connue adaptée à la densification PyC comprenant une ligne d'introduction supplémentaire permettant d'injecter le deuxième précurseur à l'état gazeux dans l'enceinte réactionnelle. Le deuxième précurseur peut être introduit dans l'enceinte réactionnelle par des moyens connus en soi communément utilisés dans la CVI PyC pour introduire les gaz réactifs.

Dans l'exemple qui vient d'être décrit en lien avec la figure 2, on forme séquentiellement par infiltration chimique en phase vapeur la première phase de matrice PyC, puis la deuxième phase de matrice comprenant la phase ZrOₓC_{y}, puis la troisième phase de matrice PyC. On obtient ainsi une matrice séquencée comprenant au moins une première et troisième couches de PyC et une deuxième couche comprenant la phase ZrOₓC_{y} intercalée entre les première et troisième couches.

Selon une variante, on peut réaliser un co-dépôt PyC+ZrOₓC_{y} par infiltration chimique en phase vapeur. Cette variante va à présent être décrite en lien avec la figure 3.

Dans l'exemple de la figure 3, le procédé comprend d'abord la formation d'une préforme fibreuse (étape E210) puis la densification de cette préforme, laquelle comprend au moins la formation d'un co-dépôt de PyC et de la phase ZrOₓC_{y} (étape E220).

On peut, en particulier, obtenir des inclusions de ZrOₓC_{y} réparties dans tout le volume de la matrice. Ces inclusions ZrOₓC_{y} sont dispersées dans la matrice de pyrocarbone.

L'intégralité de la matrice peut être formée par un co-dépôt de PyC et de la phase ZrOₓC_{y}. En variante, seule une partie de la matrice peut être formée par un co-dépôt de PyC et de la phase ZrOₓC_{y}, le reste de la matrice ayant une composition différente.

Le co-dépôt de PyC et de la phase ZrOₓC_{y} peut avoir une composition uniforme (le co-dépôt présente une composition homogène). Dans ce cas, les proportions relatives entre le gaz précurseur de PyC et le deuxième précurseur à base de zirconium sont maintenues constantes dans le mélange gazeux lors du co-dépôt.

En variante, la composition du co-dépôt de PyC et de la phase ZrOₓC_{y} peut varier au sein de la pièce. Dans ce cas, les proportions relatives entre le gaz précurseur de PyC et le deuxième précurseur à base de zirconium dans le mélange gazeux sont modifiées durant la réalisation du co-dépôt. Cette modification des proportions relatives lors du dépôt permet de contrôler localement la proportion de la phase de ZrOₓC_{y} formée dans la matrice obtenue.

De manière similaire à ce qui a été décrit plus haut, un traitement thermique de désoxygénation (étape E230) peut être réalisé une fois le co-dépôt réalisé, si cela est souhaité.

Les détails décrits plus haut relatifs à la préforme fibreuse et aux précurseurs de PyC et de ZrOₓC_{y} restent applicables à l'exemple de la figure 3.

Les proportions relatives entre le ou les précurseurs PyC et le deuxième précurseur de ZrOₓC_{y} injectés déterminent la teneur massique de la phase ZrOₓC_{y} obtenue dans la pièce finale. L'homme du métier sait, grâce à ses compétences générales, déterminer les débits à utiliser pour les différents précurseurs de sorte à obtenir la teneur souhaitée pour la phase ZrOₓC_{y} dans la pièce finale.

Quelle que soit la méthode de formation de la matrice (caléfaction ou CVI), on peut en particulier obtenir dans la pièce finale une teneur massique comprise entre 0,5% et 25%, voire entre 2% et 10%, pour la phase ZrOₓC_{y}, cette phase pouvant ou non avoir subi le traitement de désoxygénation évoqué plus haut.

### Exemples

### Exemple 1 : formation de la matrice comprenant du pyrocarbone et une phase ZrOₓC_{y} par caléfaction

Un deuxième précurseur à base de zirconium a tout d'abord été préparé.

Une quantité d'acétylacétone de 1 équivalent molaire a été introduite dans un volume de butoxyde de zirconium, sous agitation. Il a alors été obtenu un complexe métallique ayant pour formule Zr(OBut)₃(acac), où OBut désigne le ligand butoxy et acac le ligand acétylacétonate. Ce complexe a constitué le deuxième précurseur utilisé dans la densification par caléfaction.

Le deuxième précurseur formé a été ajouté à un bain de cyclohexane (premier précurseur) sous agitation afin d'obtenir un bain de caléfaction présentant une teneur massique en premier précurseur de 70% et en deuxième précurseur de 30%.

Une préforme fibreuse en fibres de carbone a été immergée dans ce bain de caléfaction et la densification de la préforme fibreuse a été réalisée en imposant une température de 1100°C. Une matrice mixte de PyC et d'une phase ZrOₓC_{y} a été obtenue (voir photographie fournie en figure 4).

### Exemple 2: formation de la matrice comprenant du pyrocarbone et une phase ZrOₓC_{y} par infiltration chimique en phase vapeur

Dans cet exemple, un premier précurseur formé d'un mélange de méthane et de propane et un deuxième précurseur formé par du butoxyde de zirconium ont été utilisés. La matrice a été formée par CVI dans une enceinte réactionnelle à une température d'environ 1000°C et sous une pression de préférence inférieure à 5 kPa. Les débits suivants ont été imposés durant le procédé CVI : débit du méthane injecté dans l'enceinte de 20 cm³.min⁻¹, débit de propane injecté dans l'enceinte de 4,3 cm³.min⁻¹ et débit de butoxyde de zirconium injecté dans l'enceinte de 3,5 cm³.min⁻¹.

Une matrice mixte de PyC comprenant des inclusions de ZrOₓC_{y} a ainsi été obtenue.

L'expression « compris(e) entre ... et ... » doit se comprendre comme incluant les bornes.

## Revendications

1. Procédé de fabrication d'une pièce de friction en matériau composite, comprenant au moins l'étape suivante :
- densification d'une préforme fibreuse en fils de carbone par une matrice comprenant au moins du pyrocarbone et une phase ZrOₓC_{y}, où 1 ≤ x ≤ 2 et 0 ≤ y ≤ 1, la matrice étant formée par caléfaction ou par infiltration chimique en phase vapeur à partir d'un premier précurseur du pyrocarbone et d'un deuxième précurseur comprenant du zirconium, le deuxième précurseur étant un complexe du zirconium comprenant un ligand alcoxy ou carboxylate lié au zirconium.

2. Procédé selon la revendication 1, dans lequel la matrice est formée par caléfaction à partir d'un bain de caléfaction comprenant le premier et le deuxième précurseurs et dans lequel la teneur massique en deuxième précurseur dans le bain de caléfaction est comprise entre 3% et 30%.

3. Procédé selon la revendication 1, dans lequel la matrice est formée par infiltration chimique en phase vapeur et dans lequel la densification comprend au moins :
- un premier cycle de densification dans lequel une première phase de matrice de pyrocarbone est formée à partir du premier précurseur à l'état gazeux,
- un deuxième cycle de densification, réalisé après le premier cycle, dans lequel une deuxième phase de matrice comprenant la phase ZrOₓC_{y} est formée au moins à partir du deuxième précurseur à l'état gazeux, et
- un troisième cycle de densification, réalisé après le deuxième cycle, dans lequel une troisième phase de matrice de pyrocarbone est formée à partir d'un troisième précurseur de pyrocarbone à l'état gazeux, identique ou différent du premier précurseur.

4. Procédé selon la revendication 1 ou 3, dans lequel la matrice est formée par infiltration chimique en phase vapeur et dans lequel la densification comprend au moins la formation d'un co-dépôt du pyrocarbone et de la phase ZrOₓC_{y} à partir d'un mélange d'un précurseur gazeux de pyrocarbone et du deuxième précurseur à l'état gazeux.

5. Procédé selon l'une quelconque des revendications 1 à 4, dans lequel le ligand alcoxy ou carboxylate est en C₂ à C₁₀.

6. Procédé selon la revendication 5, dans lequel le ligand alcoxy ou carboxylate est choisi parmi : le ligand propoxy, le ligand butoxy ou le ligand 2-éthylhexanoate.

7. Procédé selon la revendication 6, dans lequel le deuxième précurseur est choisi parmi : le propoxyde de zirconium, le butoxyde de zirconium, l'éthyl-2-hexanoate de zirconium, et leurs mélanges.

8. Procédé selon l'une quelconque des revendications 1 à 7, dans lequel le procédé comprend, en outre, un traitement thermique de désoxygénation de la phase ZrOₓC_{y} formée.

9. Procédé selon l'une quelconque des revendications 1 à 8, dans lequel la phase ZrOₓC_{y}, éventuellement désoxygénée, est présente, dans la pièce finale, en une teneur massique comprise entre 0,5% et 25%.

10. Procédé selon l'une quelconque des revendications 1 à 9, dans lequel la pièce de friction est un disque de frein.

## Patentansprüche

1. Verfahren zur Herstellung eines Reibungsteils aus Verbundwerkstoff, das wenigstens den folgenden Schritt umfasst:
- Verdichten eines Faservorformlings aus Kohlenstofffäden durch eine Matrix, die wenigstens Pyrokohlenstoff und eine ZrOₓC_{y}-Phase umfasst, wobei 1 ≤ x ≤ 2 und 0 ≤ y ≤ 1, wobei die Matrix durch Erhitzen oder durch chemische Gasphaseninfiltration aus einem ersten Vorläufer des Pyrokohlenstoffs und aus einem zweiten Vorläufer, der Zirkonium umfasst, gebildet wird, wobei der zweite Vorläufer ein Zirkoniumkomplex ist, der einen an Zirkonium gebundenen Alkoxy- oder Carboxylatliganden umfasst.

2. Verfahren nach Anspruch 1, bei dem die Matrix durch Erhitzen mittels eines Erhitzungsbades, welches den ersten und den zweiten Vorläufer umfasst, gebildet wird, und bei dem der Massengehalt an zweitem Vorläufer in dem Erhitzungsbad zwischen 3 % und 30 % beträgt.

3. Verfahren nach Anspruch 1, bei dem die Matrix durch chemische Gasphaseninfiltration gebildet wird und bei dem die Verdichtung wenigstens umfasst:
- einen ersten Verdichtungszyklus, in dem eine erste Phase der Pyrokohlenstoffmatrix aus dem ersten Vorläufer in gasförmigem Zustand gebildet wird,
- einen zweiten Verdichtungszyklus, der nach dem ersten Zyklus durchgeführt wird, wobei eine zweite Matrixphase, welche die ZrOₓC_{y}-Phase umfasst, wenigstens aus dem zweiten Vorläufer in gasförmigem Zustand gebildet wird, und
- einen dritten Verdichtungszyklus, der nach dem zweiten Zyklus durchgeführt wird, wobei eine dritte Phase der Pyrokohlenstoffmatrix aus einem dritten Pyrokohlenstoffvorläufer in gasförmigem Zustand, der mit dem ersten Vorläufer identisch oder von diesem verschieden ist, gebildet wird.

4. Verfahren nach Anspruch 1 oder 3, bei dem die Matrix durch chemische Gasphaseninfiltration gebildet wird und bei dem die Verdichtung wenigstens das Ausbilden einer Co-Abscheidung aus dem Pyrokohlenstoff und der ZrOₓC_{y}-Phase mittels einer Mischung aus einem gasförmigen Pyrokohlenstoffvorläufer und aus dem zweiten Vorläufer in gasförmigem Zustand umfasst.

5. Verfahren nach einem der Ansprüche 1 bis 4, bei dem der Alkoxy- oder Carboxylatligand ein C₂ bis C₁₀-Alkoxy- oder Carboxylatligand ist.

6. Verfahren nach Anspruch 5, bei dem der Alkoxy- oder Carboxylatligand ausgewählt ist aus: Propoxyligand, Butoxyligand oder 2-Ethylhexanoatligand.

7. Verfahren nach Anspruch 6, bei dem der zweite Vorläufer ausgewählt ist aus: Zirkoniumpropoxid, Zirkoniumbutoxid, Zirkoniumethyl-2-hexanoat und deren Mischungen.

8. Verfahren nach einem der Ansprüche 1 bis 7, wobei das Verfahren ferner eine Wärmebehandlung zur Desoxygenierung der gebildeten ZrOₓC_{y}-Phase umfasst.

9. Verfahren nach einem der Ansprüche 1 bis 8, **dadurch gekennzeichnet, dass** die eventuell desoxygenierte ZrOₓC_{y}-Phase in dem finalen Teil in einem Massengehalt im Bereich zwischen 0,5 % und 25 % vorliegt.

10. Verfahren nach einem der Ansprüche 1 bis 9, bei dem das Reibungsteil eine Bremsscheibe ist.

## Claims

1. A method of fabricating a friction part out of composite material, the method comprising at least the following step:
- densifying a carbon yarn fiber preform with a matrix comprising at least pyrolytic carbon and a ZrOₓC_{y} phase, where 1 ≤ x ≤ 2 and 0 ≤ y ≤ 1, the matrix being formed by film-boiling or by chemical vapor infiltration from a first precursor for pyrolytic carbon and a second precursor that includes zirconium, the second precursor being a zirconium complex comprising an alcoxy or carboxylate ligand bonded to zirconium.

2. A method according to claim 1, wherein the matrix is formed by film-boiling from a film-boiling bath comprising the first and second precursors, and wherein the content by weight of the second precursor in the film-boiling bath lies in the range 3% to 30%.

3. A method according to claim 1, wherein the matrix is formed by chemical vapor infiltration, and wherein the densification comprises at least:
- a first densification cycle in which a first matrix of pyrolytic carbon is formed from the first precursor in the gaseous state;
- a second densification cycle, performed after the first cycle, in which a second matrix phase comprising the ZrOₓC_{y} phase is formed from at least the second precursor in the gaseous state; and
- a third densification cycle, performed after the second cycle, in which a third matrix phase made of pyrolytic carbon is formed from a third precursor in the gaseous state for pyrolytic carbon, which third precursor may be identical to or different from the first precursor.

4. A method according to claim 1, wherein the matrix is formed by chemical vapor infiltration, and wherein the densification comprises at least forming a co-deposit of pyrolytic carbon and of the ZrOₓC_{y} phase from a mixture of a gaseous precursor for pyrolytic carbon and of the second precursor in the gaseous state.

5. A method according to claim 1, wherein the alcoxy or carboxylate ligand is a C₂ to C₁₀ ligand.

6. A method according to claim 5, wherein the alcoxy or carboxylate ligand is selected from: propoxy ligand; butoxy ligand; or 2-ethylhexanoate ligand.

7. A method according to claim 6, wherein the second precursor is selected from: zirconium propoxide; zirconium butoxide; zirconium ethyl-2-hexanoate; and mixtures thereof.

8. A method according to claim 1, wherein the method further comprises deoxygenation heat treatment of the ZrOₓC_{y} phase that has been formed.

9. A method according to claim 1, wherein the optionally deoxygenated ZrOₓC_{y} phase is present in the final part at a content by weight lying in the range 0.5% to 25%.

10. A method according to claim 1, wherein the friction part is a brake disk.
